# EUROPEAN PATENT SPECIFICATION

(11) **EP 3 539 803 B1**
(45) Date of publication and mention of the grant of the patent: **30.03.2022**
(21) Application number: 19159902.6
(22) Date of filing: 28.02.2019
(51) Int. Cl.: B60H 1/00, B60H 1/32, F25D 11/00

(54) **REFRIGERATION SYSTEM GENERATOR MONITORING**
KÜHLSYSTEMGENERATORÜBERWACHUNG
SURVEILLANCE DE GÉNÉRATEUR DE SYSTÈME DE RÉFRIGÉRATION

(30) Priority: 16.03.2018 US 201862643985 P
(43) Date of publication of application: 18.09.2019
(73) Proprietor: Carrier Corporation, Palm Beach Gardens, FL 33418 (US)
(72) Inventor: GOUGH, Jason A., Palm Beach Gardens, FL Florida 33418 (US); REPICE, Christopher G., Palm Beach Gardens, FL Florida 33418 (US); BALISTRERI, Michael, Palm Beach Gardens, FL Florida 33418 (US)
(74) Representative: Dehns

(56) References cited:
- DE-A1-102016 005 981
- US-A1- 2009 241 570
- US-A1- 2010 154 729
- US-A1- 2012 230 843

## Description

### BACKGROUND

Refrigeration systems provide the ability to control the temperature of an enclosed space. Some refrigeration systems are used as part of a heating, ventilation and air conditioning (HVAC) system for a building. Others are used for transporting items in railway cars, trailers or trucks, for example.

Some refrigeration systems depend on electrical power from a generator that is powered by an engine, such as an internal combustion engine. Ensuring adequate operation of such systems depends, at least in part, on keeping the various components in good working order. There is a need for a technique of monitoring the generator of such systems.

Relevant prior art can be found in US 2010/154729 A1, DE 10 2016 005981 A1 and US 2009/241570 A1.

### SUMMARY

The present invention defines a refrigeration system according to claim 1, including a cooling apparatus, a generator that provides electrical power to the cooling apparatus, and an engine that provides mechanical power to the generator. A processor is configured to receive a determined ambient temperature, determine an electrical load of the generator based on received voltage and current associated with the generator, receive a determined temperature of the generator, and determine whether the temperature of the generator exceeds a threshold, characterised in that the threshold is dependent on the ambient temperature and the load of the generator, and the processor is further configured to control at least the cooling apparatus in a manner that alters a load on the generator when the determined temperature of the generator exceeds the threshold.

An example embodiment having one or more features of the refrigeration system of the previous paragraph includes at least one temperature sensor that provides an indication of the temperature of the generator to the processor.

An example embodiment having one or more features of the refrigeration system of any of the previous paragraphs includes a compartment containing the generator and the engine and the temperature sensor is situated in the compartment.

In an example embodiment having one or more features of the refrigeration system of any of the previous paragraphs the temperature sensor is situated in or on the generator and provides an indication of the temperature of windings of the generator.

In an example embodiment having one or more features of the refrigeration system of any of the previous paragraphs, the determined temperature of the generator is indicative of a temperature of windings of the generator.

In an example embodiment having one or more features of the refrigeration system of any of the previous paragraphs the processor is configured to provide an output when the temperature of the generator exceeds the threshold.

In an example embodiment having one or more features of the refrigeration system of any of the previous paragraphs, the threshold is based on a predetermined relationship between ambient temperature, generator load and generator temperature.

An example embodiment having one or more features of the refrigeration system of any of the previous paragraphs includes a transport container and the cooling apparatus is configured to control a temperature in the transport container. The engine and the generator are supported for movement with the transport container.

In an example embodiment having one or more features of the refrigeration system of any of the previous paragraphs, the processor is configured to alter operation of the cooling apparatus to reduce the load on the generator.

The present invention also defines a method of monitoring a refrigeration system according to claim 9, including receiving a determined ambient temperature; determining an electrical load of the generator based on received voltage and current associated with the generator; receiving a determined temperature of the generator; and determining whether the temperature of the generator exceeds a threshold, characterized in that the threshold is dependent on the ambient temperature and the load of the generator, and by controlling at least the cooling apparatus in a manner that alters a load on the generator when the determined temperature of the generator exceeds the threshold.

An example embodiment having one or more features of the method of the previous paragraph includes using at least one temperature sensor to obtain an indication of the temperature of the generator.

In an example embodiment having one or more features of the method of any of the previous paragraphs, the temperature sensor is situated in a compartment containing the generator and the engine.

In an example embodiment having one or more features of the method of any of the previous paragraphs, the temperature sensor is situated in or on the generator and provides an indication of the temperature of windings of the generator.

In an example embodiment having one or more features of the method of any of the previous paragraphs, the determined temperature of the generator is indicative of a temperature of windings of the generator.

An example embodiment having one or more features of the method of any of the previous paragraphs includes providing an output when the temperature of the generator exceeds the threshold.

In an example embodiment having one or more features of the method of any of the previous paragraphs, the threshold is based on a predetermined relationship between ambient temperature, generator load and generator temperature.

In an example embodiment having one or more features of the method of any of the previous paragraphs, controlling at least the cooling apparatus comprises altering operation of the cooling apparatus to reduce the load on the generator.

Variations and modifications to at least one disclosed example embodiment will become apparent to those skilled in the art from the following detailed description. The drawings that accompany the detailed description can be briefly described as follows.

### BRIEF DESCRIPTION OF THE DRAWINGS

Figure 1 schematically illustrates a refrigeration system designed according to an embodiment of this invention.
Figure 2 is a flowchart diagram summarizing an example method of monitoring a refrigeration system designed according to an embodiment of this invention.

### DETAILED DESCRIPTION

Embodiments of this invention facilitate monitoring the generator of a refrigeration system to provide enhanced control over the function of the system. Monitoring a generator according to an embodiment of this invention facilitates detecting or predicting whether the generator is performing properly to provide optimum refrigeration system performance. When an undesired generator condition, such as winding temperature, exists, control over the refrigeration system operation allows for achieving the desired condition.

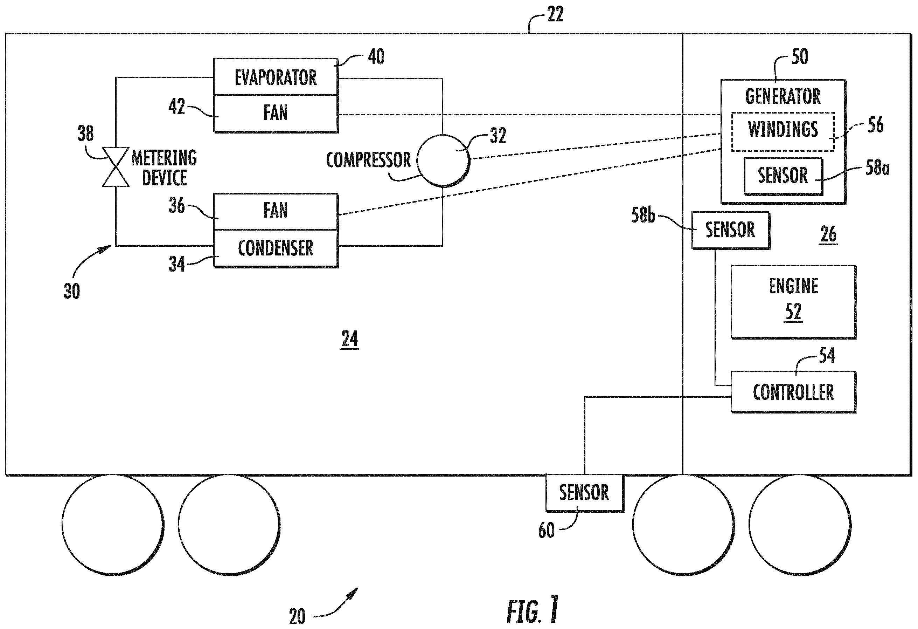

Figure 1 schematically illustrates a refrigeration system 20. In the illustrated example, the refrigeration system 20 is a transport refrigeration system. The illustrated example includes a transport container 22, which may be a railway car or truck trailer, for example. The example transport container 22 includes a temperature controlled portion 24 and an engine compartment 26.

A cooling apparatus 30 provides refrigeration or air conditioning to the temperature controlled compartment 24. The example cooling apparatus 30 includes a compressor 32 that delivers refrigerant to a condenser 34. A fan 36 associated with the condenser 34 causes airflow across the condenser 34, which in an air conditioning mode removes heat from the refrigerant in the condenser 34. A metering device 38, such as an expansion valve, is situated between the condenser 34 and an evaporator 40. A fan 42 associated with the evaporator directs air over the evaporator 40 and into the temperature controlled compartment 24. The cooling apparatus 30 is schematically illustrated for discussion purposes and embodiments of this invention are not limited to any particular cooling apparatus configuration. Those skilled in the art who have the benefit of this description will understand how the components of the cooling apparatus 30 are situated relative to the temperature controlled compartment 24 to have the desired cooling effect and will be able to select a cooling apparatus arrangement that meets their particular needs.

A generator 50 provides electrical power to the electrically operated components of the cooling apparatus 30, such as the compressor 32 and the fans 36 and 42. An engine 52 provides mechanical power to the generator 50. The engine 52 in some embodiments is an internal combustion engine, which may operate on diesel fuel. A processor 54, which includes a computing device and associated memory, monitors operation of the generator 50 to detect any existing or potential malfunction of the generator 50 that might adversely affect the operation of the refrigeration system 20. In the illustrated example, the processor 54 utilizes information indicative of a temperature of windings 56 of the generator 50 to determine an operating condition of the generator 50.

In the illustrated example, a temperature sensor 58 is situated within the compartment 26 and provides an indication of a temperature of the windings 56. The sensor 58 in the illustrated example includes a first temperature sensor 58a, such as a thermistor, on the windings 56 or otherwise within the generator 50 where the sensor 58a can detect the temperature of the windings. The first temperature sensor 58a provides an indication of the temperature of the windings 56 to the processor 54. The illustrated example includes a second temperature sensor 58b within the engine compartment 26. The second temperature sensor 58b is in the vicinity of at least one of the generator 50 and the engine 52 and, while not directly measuring the temperature of the generator windings 56, provides an indication of a corresponding temperature of those windings 56 to the processor 54.

Another temperature sensor 60 is situated to provide information to the processor 54 regarding an ambient temperature in the vicinity of the refrigeration system 20. The ambient temperature has an effect on the temperature detected by the sensor 58 at least because the ambient temperature affects a temperature within the compartment 26 and an operating temperature of the engine 52.

The processor 54 is also configured to determine a load of the generator 50. According to the invention, the processor 54 uses known techniques based on voltage and current associated with the generator 50 to determine the generator load.

The processor 54 has access to predetermined relationship information regarding a relationship between the ambient temperature, the temperature of the generator windings 56 and the generator load. The load on the generator 50 dictates how much heat is generated in the windings 56. In some embodiments, such information is stored in the memory of the processor 54. In other embodiments, the processor 54 accesses such information from a remote memory or database using known communication techniques.

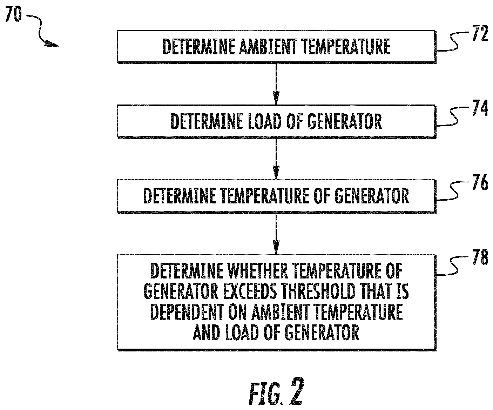

Figure 2 includes a flowchart diagram 70 that summarizes an example method of monitoring the generator 50 of the refrigeration system 20. At 72, the processor 54 utilizes information from the sensor 60 to determine the ambient temperature. At 74, the processor 54 determines the load of the generator 50, which will depend in part on the operation of the cooling apparatus 30. The processor 54 also determines a temperature of the generator 50 at 76. This temperature determination is based on information from at least one of the sensors 58a and 58b. In some examples, the determined temperature is the temperature of the windings 56 as indicated by the sensor 58a.

At 78, the processor 54 determines whether the temperature of the generator 50 exceeds a threshold, which is dependent on the ambient temperature and the load of the generator 50. Processor 54 utilizes the predetermined relationship among the ambient temperature, generator load and generator temperature to determine the threshold appropriate for the monitored operating conditions. The predetermined relationship information includes different thresholds for different combinations of temperature and load conditions. For example, a particular generator load may have an associated generator temperature that is acceptable for a first ambient temperature but is considered too high for a second, lower ambient temperature. When the ambient temperature is higher, the expected or acceptable generator temperature may also be higher under some conditions. In some embodiments, empirical data is collected as baseline data to define or establish the relationship between generator winding temperatures, generator loads and ambient temperatures for setting or selecting thresholds that are useful for providing an indication of acceptable or satisfactory generator performance.

In the event that the determined temperature of the generator exceeds the appropriate threshold, the processor 54 provides an output indicating that the generator 50 is or may soon be operating in an undesired or less than optimum manner. In some cases the output of the processor 54 includes a warning or alarm indicating that the generator 50 requires service. In some embodiments, the thresholds are selected to result in an output from the processor 54 that indicates when preventative maintenance would be useful for improve generator reliability and the useful life of the generator 50.

In some embodiments the processor 54 controls operation of the refrigeration system 20 in a manner that will permit the generator winding temperature to decrease. For example, the processor 54 will cause the cooling apparatus 30 of the refrigeration system 20 to operate in a manner that places a lower load on the generator 50, which will allow the winding temperature to decrease. The processor 54 in some examples repeatedly or continuously monitors the temperature of the generator 50 until the temperature returns to a level below the threshold and then returns the operation of the cooling apparatus 30 to the state of operation that existed prior to the generator temperature exceeding the threshold.

The generator monitoring and refrigeration system control of the disclosed example embodiment enhances the overall function of the refrigeration system 20 by providing enhanced control over the operating condition of the generator 50, which is necessary for providing adequate electrical power to the components of the cooling apparatus 30.

The preceding description is exemplary rather than limiting in nature.

Variations and modifications to the disclosed examples may become apparent to those skilled in the art that do not depart from the scope of the invention, which is defined by the appended claims.

## Claims

1. A refrigeration system (20), comprising:
a cooling apparatus (30);
a generator (50) that provides electrical power to the cooling apparatus (30);
an engine (52) that provides mechanical power to the generator (50); and
a processor (54) configured to
receive a determined ambient temperature,
determine an electrical load of the generator (50) based on received voltage and current associated with the generator,
receive a determined temperature of the generator (50), and
determine whether the temperature of the generator (50) exceeds a threshold,
**characterised in that**:
the threshold is dependent on the ambient temperature and the load of the generator (50), and
the processor (54) is configured to control at least the cooling apparatus (30) in a manner that alters a load on the generator (50) when the determined temperature of the generator (50) exceeds the threshold.

2. The refrigeration system of claim 1, comprising at least one temperature sensor (58a, 58b) that provides an indication of the temperature of the generator (50) to the processor.

3. The refrigeration system of claim 2, comprising a compartment (26) containing the generator (50) and the engine (52) and wherein the temperature sensor (58b) is situated in the compartment (26).

4. The refrigeration system of claims 2 or 3, wherein the temperature sensor (58a) is situated in or on the generator (50) and provides an indication of the temperature of windings (56) of the generator (50).

5. The refrigeration system of any preceding claim, wherein the determined temperature of the generator (50) is indicative of a temperature of windings (56) of the generator (50).

6. The refrigeration system of any preceding claim, wherein the processor (54) is configured to provide an output when the temperature of the generator (50) exceeds the threshold,
and/or wherein the threshold is based on a predetermined relationship between ambient temperature, generator load and generator temperature.

7. The refrigeration system of any preceding claim, wherein the processor (54) is configured to alter operation of the cooling apparatus (30) to reduce the load on the generator (50).

8. A transport container (22) comprising the refrigeration system (20) of any preceding claim, wherein
the cooling apparatus (30) is configured to control a temperature in the transport container (22); and
the engine (52) and the generator (50) are supported for movement with the transport container (22).

9. A method of monitoring a refrigeration system (20) that includes a cooling apparatus (30), a generator (50) that provides electrical power to the cooling apparatus (30) and an engine (52) that provides power to the generator (50), the method comprising using a processor (54) for:
receiving a determined ambient temperature;
determining an electrical load of the generator (50) based on received voltage and current associated with the generator;
receiving a determined temperature of the generator (50);
determining whether the temperature of the generator (50) exceeds a threshold, wherein the threshold is dependent on the ambient temperature and the load of the generator (50); and
controlling at least the cooling apparatus (30) in a manner that alters a load on the generator (50) when the determined temperature of the generator (50) exceeds the threshold.

10. The method of claim 9, comprising using at least one temperature sensor (58a, 58b) to obtain an indication of the temperature of the generator (50).

11. The method of claim 10, wherein the temperature sensor (58b) is situated in a compartment (26) containing the generator (50) and the engine (52).

12. The method of claim 10 or 11, wherein the temperature sensor (58a) is situated in or on the generator (50) and provides an indication of the temperature of windings (56) of the generator (50).

13. The method of any of claims 9 to 12, wherein the determined temperature of the generator (50) is indicative of a temperature of windings (56) of the generator (50).

14. The method of any of claims 9 to 13, comprising providing an output when the temperature of the generator (50) exceeds the threshold,
and/or wherein the threshold is based on a predetermined relationship between ambient temperature, generator load and generator temperature.

15. The method of any of claims 9 to 14, wherein controlling at least the cooling apparatus (30) comprises altering operation of the cooling apparatus (30) to reduce the load on the generator (50).

## Patentansprüche

1. Kühlsystem (20), umfassend:
eine Kühleinrichtung (30);
einen Generator (50), welcher elektrischen Strom an die Kühleinrichtung (30) liefert;
einen Motor (52), welcher mechanische Leistung an den Generator (50) liefert; und
einen Prozessor (54), welcher konfiguriert ist, um:
eine bestimmte Umgebungstemperatur zu empfangen,
eine elektrische Last des Generators (50) auf Basis von empfangener Spannung und empfangenem Strom zu bestimmen, welche mit dem Generator verknüpft sind,
eine bestimmte Temperatur des Generators (50) zu empfangen, und
zu bestimmen, ob die Temperatur des Generators (50) einen Schwelle überschreitet,
**dadurch gekennzeichnet, dass**:
die Schwelle von der Umgebungstemperatur und der Last des Generators (50) abhängig ist, und
der Prozessor (54) konfiguriert ist, um zumindest die Kühleinrichtung (30) auf eine Art zu regeln, welche eine Last an dem Generator (50) verändert, wenn die bestimmte Temperatur des Generators (50) die Schwelle überschreitet.

2. Kühlsystem nach Anspruch 1, umfassend zumindest einen Temperatursensor (58a, 58b) welcher eine Angabe der Temperatur des Generators (50) an den Prozessor liefert.

3. Kühlsystem nach Anspruch 2, umfassend ein Abteil (26), welches den Generator (50) und den Motor (52) enthält, und wobei der Temperatursensor (58b) sich in dem Abteil (26) befindet.

4. Kühlsystem nach Anspruch 2 oder 3, wobei der Temperatursensor (58a) sich in oder auf dem Generator (50) befindet und eine Angabe der Temperatur von Wicklungen (56) des Generators(50) liefert.

5. Kühlsystem nach einem der vorstehenden Ansprüche, wobei die bestimmte Temperatur des Generators (50) eine Temperatur von Wicklungen (56) des Generators (50) angibt.

6. Kühlsystem nach einem der vorstehenden Ansprüche, wobei der Prozessor (54) konfiguriert ist, um eine Ausgabe zu liefern, wenn die Temperatur des Generators (50) die Schwelle überschreitet,
und/oder wobei die Schwelle auf einer vorbestimmten Beziehung zwischen Umgebungstemperatur, Generatorlast und Generatortemperatur basiert.

7. Kühlsystem nach einem der vorstehenden Ansprüche, wobei der Prozessor (54) konfiguriert ist, um Betrieb der Kühleinrichtung (30) zu verändern, um die Last an dem Generator (50) zu verringern.

8. Transportbehälter (22), umfassend das Kühlsystem (20) nach einem der vorstehenden Ansprüche, wobei
die Kühleinrichtung (30) konfiguriert ist, um eine Temperatur in dem Transportbehälter (22) zu regeln; und
der Motor (52) und der Generator (50) für Bewegung mit dem Transportbehälter (22) gestützt sind.

9. Verfahren zum Überwachen eines Kühlsystems (20), welches eine Kühleinrichtung (30), einen Generator (50), welcher elektrischen Strom an die Kühleinrichtung (30) liefert, und einen Motor (52), welcher Leistung an den Generator (50) liefert, beinhaltet, das Verfahren umfassend Verwendung eines Prozessor (54) für:
Empfangen einer bestimmten Umgebungstemperatur;
Bestimmen einer elektrischen Last des Generators (50) auf Basis von empfangener Spannung und empfangenem Strom, welche mit dem Generator verknüpft sind;
Empfangen einer bestimmten Temperatur des Generators (50);
Bestimmen, ob die Temperatur des Generators (50) eine Schwelle überschreitet, wobei die Schwelle von der Umgebungstemperatur und der Last des Generators (50) abhängig ist; und
Regeln zumindest der Kühleinrichtung (30) auf eine Art, welche eine Last an dem Generator (50) verändert, wenn die bestimmte Temperatur des Generators (50) die Schwelle überschreitet.

10. Verfahren nach Anspruch 9, umfassend Verwenden zumindest eines Temperatursensors (58a, 58b), um eine Angabe der Temperatur des Generators (50) zu erhalten.

11. Verfahren nach Anspruch 10, wobei der Temperatursensor (58b) sich in einem Abteil (26) befindet, welches den Generator (50) und den Motor (52) enthält.

12. Verfahren nach Anspruch 10 oder 11, wobei der Temperatursensor (58a) sich in oder auf dem Generator (50) befindet und eine Angabe der Temperatur von Wicklungen (56) des Generators (50) liefert.

13. Verfahren nach einem der Ansprüche 9 bis 12, wobei die bestimmte Temperatur des Generators (50) eine Temperatur von Wicklungen (56) des Generators (50) angibt.

14. Verfahren nach einem der Ansprüche 9 bis 13, umfassend Liefern einer Ausgabe, wenn die Temperatur des Generators (50) die Schwelle überschreitet,
und/oder wobei die Schwelle auf einer vorbestimmten Beziehung zwischen Umgebungstemperatur, Generatorlast und Generatortemperatur basiert.

15. Verfahren nach einem der Ansprüche 9 bis 14, wobei Regeln zumindest der Kühleinrichtung (30) Verändern des Betriebs der Kühleinrichtung (30) umfasst, um die Last an dem Generator (50) zu verringern.

## Revendications

1. Système de réfrigération (20), comprenant :
un appareil de refroidissement (30) ;
un générateur (50) qui fournit une puissance électrique à l'appareil de refroidissement (30) ;
un moteur (52) qui fournit une puissance mécanique au générateur (50) ; et
un processeur (54) configuré pour
recevoir une température ambiante déterminée,
déterminer une charge électrique du générateur (50) sur la base de la tension et du courant reçus associés au générateur,
recevoir une température déterminée du générateur (50), et
déterminer si la température du générateur (50) excède un seuil,
**caractérisé en ce que** :
le seuil dépend de la température ambiante et de la charge du générateur (50), et
le processeur (54) est configuré pour commander au moins l'appareil de refroidissement (30) d'une manière qui modifie une charge sur le générateur (50) lorsque la température déterminée du générateur (50) excède le seuil.

2. Système de réfrigération selon la revendication 1, comprenant au moins un capteur de température (58a, 58b) qui fournit une indication de la température du générateur (50) au processeur.

3. Système de réfrigération selon la revendication 2, comprenant un compartiment (26) contenant le générateur (50) et le moteur (52) et dans lequel le capteur de température (58b) est situé dans le compartiment (26).

4. Système de réfrigération selon la revendication 2 ou 3, dans lequel le capteur de température (58a) est situé dans ou sur le générateur (50) et fournit une indication de la température d'enroulements (56) du générateur (50).

5. Système de réfrigération selon l'une quelconque des revendications précédentes, dans lequel la température déterminée du générateur (50) indique une température d'enroulements (56) du générateur (50).

6. Système de réfrigération selon l'une quelconque des revendications précédentes, dans lequel le processeur (54) est configuré pour fournir une sortie lorsque la température du générateur (50) excède le seuil,
et/ou dans lequel le seuil est basé sur un rapport prédéterminé entre la température ambiante, la charge de générateur et la température de générateur.

7. Système de réfrigération selon l'une quelconque des revendications précédentes, dans lequel le processeur (54) est configuré pour modifier le fonctionnement de l'appareil de refroidissement (30) pour réduire la charge sur le générateur (50).

8. Contenant de transport (22) comprenant le système de réfrigération (20) selon l'une quelconque des revendications précédentes, dans lequel
l'appareil de refroidissement (30) est configuré pour commander une température dans le contenant de transport (22) ; et
le moteur (52) et le générateur (50) sont supportés pour le mouvement avec le contenant de transport (22).

9. Procédé de surveillance d'un système de réfrigération (20) qui comporte un appareil de refroidissement (30), un générateur (50) qui fournit une puissance électrique à l'appareil de refroidissement (30) et un moteur (52) qui fournit de la puissance au générateur (50), le procédé comprenant l'utilisation d'un processeur (54) pour :
recevoir une température ambiante déterminée ;
déterminer une charge électrique du générateur (50) sur la base de la tension et du courant reçus associés au générateur ;
recevoir une température déterminée du générateur (50) ;
déterminer si la température du générateur (50) excède un seuil ou ne l'excède pas, dans lequel le seuil dépend de la température ambiante et de la charge du générateur (50) ; et
commander au moins l'appareil de refroidissement (30) d'une manière qui modifie une charge sur le générateur (50) lorsque la température déterminée du générateur (50) excède le seuil.

10. Procédé selon la revendication 9, comprenant l'utilisation d'au moins un capteur de température (58a, 58b) pour obtenir une indication de la température du générateur (50).

11. Procédé selon la revendication 10, dans lequel le capteur de température (58b) est situé dans un compartiment (26) contenant le générateur (50) et le moteur (52).

12. Procédé selon la revendication 10 ou 11, dans lequel le capteur de température (58a) est situé dans ou sur le générateur (50) et fournit une indication de la température d'enroulements (56) du générateur (50).

13. Procédé selon l'une quelconque des revendications 9 à 12, dans lequel la température déterminée du générateur (50) indique une température d'enroulements (56) du générateur (50).

14. Procédé selon l'une quelconque des revendications 9 à 13, comprenant la fourniture d'une sortie lorsque la température du générateur (50) excède le seuil,
et/ou dans lequel le seuil est basé sur un rapport prédéterminé entre la température ambiante, la charge de générateur et la température de générateur.

15. Procédé selon l'une quelconque des revendications 9 à 14, dans lequel la commande d'au moins l'appareil de refroidissement (30) comprend la modification du fonctionnement de l'appareil de refroidissement (30) pour réduire la charge sur le générateur (50).
